# EUROPÄISCHE PATENTANMELDUNG

(11) **EP 1 677 363 A1**
(43) Veröffentlichungstag der Anmeldung: **05.07.2006**
(21) Anmeldenummer: 05075011.6
(22) Anmeldetag: 04.01.2005
(51) Int. Cl.: H01L 31/048, H01L 31/0216

(54) **Solarmodul zur Dachintegration**

(71) Anmelder: CIS solar production GmbH & Co. KG, 12435 Berlin (DE)
(72) Erfinder: Kalberlah, Klaus, 12435 Berlin (DE); Schlemper, Klaus, 12524 Berlin (DE)
(74) Vertreter: Hengelhaupt, Jürgen

(57) **Zusammenfassung**

Flexible Folienmodule, hergestellt durch Lamination von kristallinen Siliziumzellen zwischen dünne Kunststoff-Folien, sind altbekannt, jedoch für die Dachintegration ungeeignet, weil sie nicht die sogenannte Hagelschlagprüfung nach IEC 61215 bestehen. Es wird daher vorgeschlagen, statt einer Kunststoff-Folie eine speziell ausgeformte Kunststoffplatte zu verwenden, die Zellen in diese Platte mittels Kunstharz einzugießen und ggf. zusätzlich in der Mitte der Zelle einen Abstandshalter einzubauen.

## Beschreibung

Die Erfindung betrifft ein Solarmodul zur Dachintegration, bestehend aus mehreren kristallinen Siliziumzellen, die gemeinsam mit einer Abdeckung versehen sind, in die auf der sonnenabgewandten Seite Vertiefungen zur Aufnahme der Siliziumzellen mit einer mindestens der Dicke der Siliziumzellen entsprechenden Tiefe eingebracht sind.

Übliche Solarstrom-Standard-Module bestehen vorderseitig aus einer relativ bruchfesten Silikatglasscheibe und rückseitig aus einer feuchtigkeitsundurchlässigen KunststoffVerbundfolie. Dazwischen "einlaminiert", üblicherweise mittels EVA-Schmelzklebefolie, werden kristalline Silizium-Solarzellen typischerweise über 100 mm x 100 mm groß und ca. 0,3 mm dick, das heißt sehr bruchempfindlich. Diese "Laminate" erhalten einen Aluminiumrahmen und eine elektrische Anschlussdose und werden üblicherweise "Standard-Module" genannt. Ihre Prüfung/Zertifizierung erfolgt nach IEC 61215, wozu eine äußerst harte HagelschlagPrüfung zählt.

Aus DE 27 57 493 A1 ist auch eine Solarzellenanordnung mit einer lichtdurchlässigen Abdeckung aus einem Kunststoff-Spritzgussteil bekannt. Die Solarzellen sind in Vertiefungen dieses Spritzgussteiles eingelegt. Die Vertiefungen sind wabenartig angeordnet, wodurch die Gesamtanordnung durch die verbleibenden Stege zwischen den einzelnen Solarzellen besonders steif sein soll.

Daneben und in bedeutend geringerem Umfang sind so genannte Folienmodule bekannt geworden, das heißt die Einbettung von kristallinen Solarzellen zwischen zwei Kunststofffolien, wodurch ein mehr oder weniger flexibles Laminat entsteht. Derartige Folienmodule werden zur Verklebung auf Bootsdecks, Wohnwagen Caravans etc. verwendet, erfüllen aber die Hagelschlagprüfung nicht, so dass sie zur Verwendung als integrierter Bestandteil von Metalldächern (BIPV, "building integrated photovoltaics") nicht geeignet sind.

Metalldächer, auf deren einzelne Bauteile ("Dachscharen") werksseitig bereits flexible Folienmodule aufgeklebt wurden, sind etwa 1993 in den USA entwickelt worden und finden inzwischen in steigendem Umfang auch in Europa Verwendung. Der Vorteil einer derartigen Kombination von flexiblen Solar-Laminaten mit dem Blechdach statt einer nachträglichen Montage von Standardmodulen auf ein konventionelles Blechdach liegt, zumindest im Prinzip, in der Kosteneinsparung (ca. 15 %) für die Rahmen, Anschlussdosen, Befestigungsteile und für die bauseitige Montagearbeit. In der Praxis ist BIPV teilweise eher teurer als die Montage von Standardmodulen auf einem Metalldach, weil für die Herstellung ausschließlich teure Folienmodule zur Verfügung stehen. Diese Laminate sind flexibel, weil statt der bruchempfindlichen kristallinen Solarzellen bruchfeste, flexible Bandzellen, hergestellt durch Aufdampfen von Dünnschicht-Silizium auf Edelstahl, Verwendung finden. Bisher noch nicht marktreif sind verschiedene Entwicklungen, aSi oder CIS direkt auf flexible Kunststofffolien abzuscheiden.

Tatsächlich stehen somit derzeit für die Verklebung auf Blechdächern, Fassaden usw. geeignete, flexible Folienmodule zur Verfügung, die neben einem hohen Preis auch einen geringen Wirkungsgrad (bei 6 %, entsprechend 60 Watt pro Quadratmeter unter STC) haben und eine geringe Alterungsbeständigkeit aufweisen.

Die Kombination von Metalldach und flexiblem Solar-Laminat hat, außer potentiellen Preisvorteilen und der werksseitigen Fertigung, das interessante Potential, zugleich Solarwärme gewinnen zu können. Will man jedoch, wegen der genannten Nachteile, zur BIPV-Herstellung keine Silizium-/Edelstahl-Laminate verwenden, so ergibt sich die Problematik, dass andere flexible Dünnschichtzellen (z.B. Bandzellen nach der CIS-Technologie der IST nach DE 196 34 580 A1) erst in einigen Jahren am Markt zur Verfügung stehen werden, andererseits andere Folienmodule für diesen Anwendungsbereich nicht geeignet sind, weil die einlaminierten, kristallinen Siliziumzellen bei der IEC61215 - Hagelschlagprüfung - beschädigt werden.

Von Fachleuten wird einerseits berichtet, dass umfangreiche Versuche zur Modifikation von Folienmodulen in eine hagelschlagsicheren Variante, beispielsweise durch sonnenseitige Verwendung einer Abdeckscheibe aus schlagfestem Polycarbonat, angestellt wurden, jedoch fehlgeschlagen sind.

Die Problemlösung ist also offensichtlich nicht trivial; andererseits bestehen handelsübliche Folienmodule immerhin die für Baumaterial übliche, weniger strenge deutsche "Hagelschlagprüfung Bau", was nahe legt, dass die erforderlichen Zusatzmaßnahmen zur Erlangung von IEC61215 nicht unbedingt umfangreich sein müssen.

In dieser Situation ist es Aufgabe der vorliegenden Erfindung, unter Verwendung kristalliner Silizium-Solarzellen ein hagelschlagsicheres und somit BIPV-geeignetes Folienmodul anzugeben.

Erfindungsgemäß wird die Aufgabe gelöst durch die Merkmale des Anspruchs 1. Zweckmäßige Ausgestaltungen sind Gegenstand der Unteransprüche.

Hagelschlagsicherheit und damit Eignung für den BIPV-Bereich wird erreicht, indem zunächst relativ kleine Silizium-Solarzellen von vorzugsweise größerer Dicke, dass heißt Zellen, wie sie in der Frühzeit der Photovoltaik üblich waren, verwendet werden, beispielsweise monokristalline Zellen 80 mm x 80 mm x 0,4 mm. Diese Zellenabmaße bieten sich auch deswegen an, weil BIPV-Laminate schmal (ca, 40 cm) und lang sein sollen, um zu den Baumaßen von Dachscharen zu passen.

Für die Abdeckung auf der sonnenzugewandten Seite des flexiblen Solar-Laminats wird eine relativ dicke und somit relativ starre Platte aus schlagfestem Kunststoff verwendet, die einerseits durch eingeformte Dünnstellen zwischen den Solarzellen in der Art eines Dünnfilm-Scharniers flexibel gemacht wird und die andererseits auf der sonnenabgewandten Seite Vertiefungen enthält, die mindestens ebenso tief sind wie die Solarzellen dick, so dass die Zellen vollständig in die Vertiefung eingebettet werden können.
Bei Hagelschlag auf die Oberseite der sonnenseitigen Abdeckung wird der Impuls über die "dicken Bereiche" auf die Rückseite des Laminats bzw. auf die Dachschare abgetragen, die in der Vertiefung befindliche Solarzelle wird weniger stark auf Schock beansprucht, als dies bei einer Einbettung zwischen "glatten" Folien der Fall wäre. Verstärken lässt sich dieser Effekt, falls erforderlich, durch Einbau einer "Abstützung" in Zellenmitte. Die Lochung einer kristallinen Solarzelle mittels Laser stellt heute kein Problem mehr dar. Beim Einbau der Solarzelle wird als Abstützung ein Stift mit verbreitertem Kopf eingebracht, dessen Länge wiederum eine kraftschlüssige Verbindung zwischen sonnenseitiger und rückseitiger Abdeckung des Solarmoduls sicherstellt.

Obwohl die Absorption von Strahlung durch den eingebrachten Stift bzw. durch dessen Kopf ohnehin gering ist, wird dieser vorteilhafterweise aus einem glasklaren, schlagfesten und UV-beständigen Kunststoff ausgeführt.

Üblicherweise erfolgt die Lamination von Zellen in Solarmodulen durch EVA-Schmelzklebefolie. Bei der vorliegenden Abdeckplatte mit Vertiefungen ist jedoch angeraten, die Zellen in Gießharz einzubetten, vergleichbar der in den frühen Jahren der Solarstromtechnik verwendeten Silicon-Einbettung. Heute stehen so genannte "Lupenharze" (Cycloalophatische Epoxydharze) zur Verfügung, die hochtransparent, UV-beständig, ohne Luftzufuhr kalthärtend, in der Härte einstellbar und im Preis nicht teurer als EVA sind. Insbesondere die "dauerelastische" Einstellung könnte vorteilhaft sein, den Impakt der Hagelkörner abzufangen.

Es steht zu vermuten, dass bei den bekannten, nicht hagelschlagsicheren Modulen bei der Durchbiegung durchaus Zellbruch stattfindet, dieser Jedoch ohne schädliche Auswirkungen bleibt, weil die metallischen Leiterbahnen auf der Zellenoberseite eine Parallelschaltung der Zellenbruchstücke bewirken. Analog hierzu wird als weitere Variante bzw. Verbesserung vorgesehen, die transparente Vergussmasse, mit welcher die Zellen in die Vertiefungen der sonnenseitigen Abdeckung eingebettet werden, elektrisch leitfähig zu machen. Ein Bruch der kristallinen Siliziumzelle bleibt dann (aus dem genanten Grund) ohne Folgen. Alternativ wird die Solarzelle vorderseitig mit verstärkten Leitbahnen aus duktilem Metall ausgeführt, so dass beim Zellenbruch eine Parallelschaltung erhalten bleibt.

Die Erfindung soll anhand von Ausführungsbeispielen näher erläutert werden. In den zugehörigen Zeichnungen zeigen:
- Fig. 1: eine erste Variante einer erfindungsgemäßen Abdeckung im Querschnitt,
- Fig. 2: die Abdeckung gemäß Fig. 1 in der Draufsicht von unten,
- Fig. 3: die Abdeckung komplett mit den eingesetzten Solarzellen,

- Fig. 4: eine weitere Variante mit einer zusätzlichen Verstiftung der Solarzellen,
- Fig. 5: eine mögliche Strukturierung einer Abdeckung,
- Fig. 6: die Verschaltung der Solarzellen,
- Fig. 7: eine Anordnung der Abdeckung mit zusätzlichen Deckeln,
- Fig. 8: einen einzelnen Deckel und .
- Fig. 9: eine Anordnung mit Deckeln, aber ohne Verstiftung.

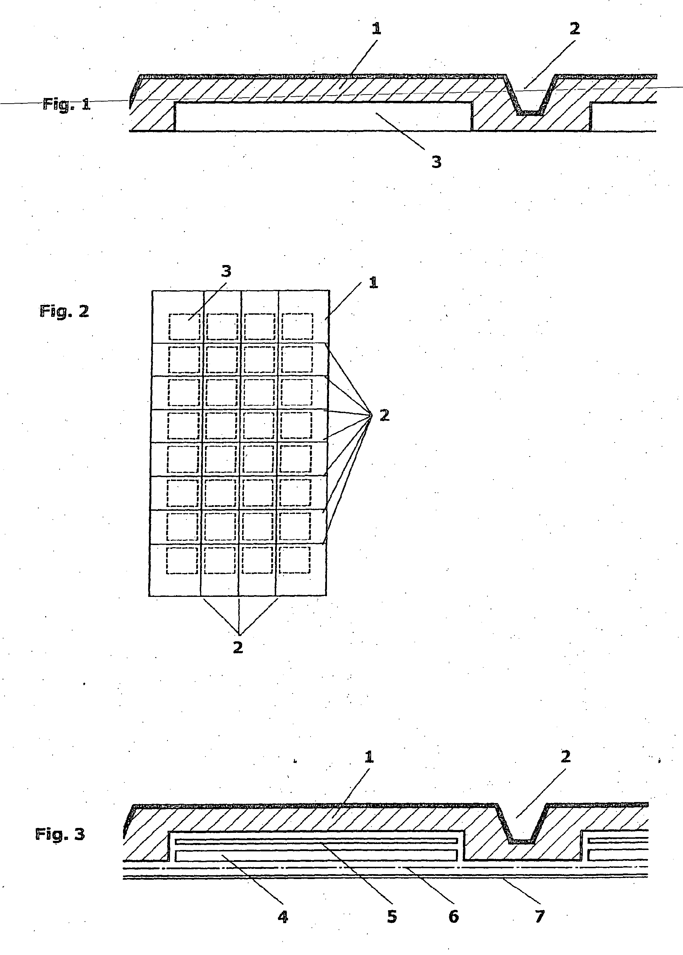

Fig. 1 zeigt die erfindungsgemäße Ausbildung einer sonnenseitigen Abdeckplatte 1 mit Nuten 2 auf der "Oberseite" und Vertiefungen 3 auf der Unterseite. Das Gitterwerk der Nuten (siehe Fig. 2)gewährleistet eine Biegbarkeit der Platte in Längs- und Querrichtung. Die Vertiefungen 3 dienen zur Aufnahme von Solarzellen 4. Die sonnenseitige Abdeckplatte 1 kann hergestellt werden, indem Polycarbonat-Plattenmaterial thermoplastisch mit zwei Matrizen entsprechend verformt wird. Selbstverständlich ist auch, bei entsprechend höheren Werkzeug- und niedrigeren Stückkosten, eine Herstellung im Spritzgussverfahren möglich.

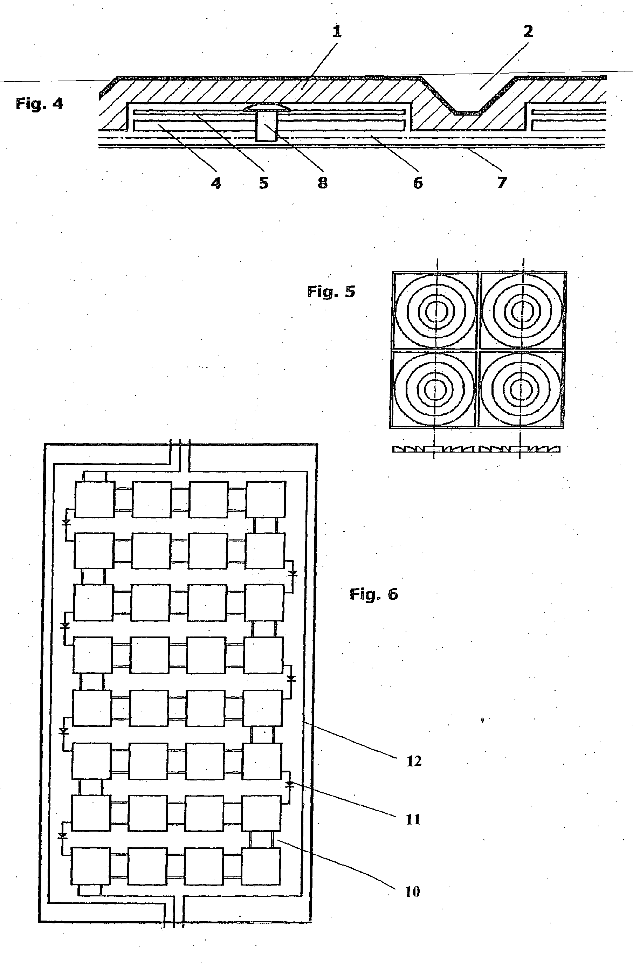

Fig. 3 zeigt einen Querschnitt durch das komplette Laminat. Die Solarzellen 4 sind mit Gießharz 5 in die Vertiefungen 3 eingebracht, rückseitig wurde eine Klebeschicht 6 mit EVA-Schmelzkleber oder doppelseitiger Klebefolie eine lichtundurchlässige Abdeckung 7 aufgebracht. Letztere könnte aus den bei Standard-Solarmodulen üblichen "Rückseitenfolie" bestehen, jedoch speziell bei Einbau von Abstützungen, wie sie Fig. 4 zeigt, auch aus weniger flexiblem Material, beispielsweise 0,2 mm Edelstahl.

Fig. 4 zeigt die zusätzliche Verwendung von Abstützungen (vorzugsweise aus transparentem Kunststoff). Die Lochung in der kristallinen Solarzelle und der Einbau mit Gießharz muss so erfolgen, dass ein Stift 8 im Bereich von zehntel Millimetern frei durch die Zelle hindurchgleiten kann und nicht, beispielsweise durch Verklebung, Kräfte auf die Zelle überträgt.

Fig. 5 zeigt eine Strukturierung der sonnenseitigen Abdeckplatte 1 im Bereich der Vertiefung 3 derart, dass sowohl der Effekt der mechanischen Versteifung wie auch ein lichtsammelnder Effekt auftritt (Prinzip Fresnel-Linse). Die dargestellte Struktur mit rahmenartiger Vertiefung und vier kleinen Fresnel-Linsen stellt einen Sonderfall dar; üblicherweise wird die Zellenfläche von einer einzigen Fresnel-Struktur überspannt.

Fig. 6 zeigt die Reihenverschaltung von 36 Solarzellen 4 zu einem Solarmodul. Die Besonderheit liegt einerseits in der unüblichen, mäanderförmigen Verschaltung durch Zellenverbinder 10 der Zellen 4 mit einer relativ großen Anzahl eingelegter Bypass-Dioden 11, wodurch das BIPV-Laminat weitgehend unempfindlich gegen Teil-Abschattung wird. Außerdem ist eine Durchgangsverdrahtung 12 eingearbeitet, da bei einer Kabelverlegung unterhalb der Dachhaut zahlreiche Dachdurchbrüche zum Anschluss der Laminate benötigt werden, was schon allein aus Gründen der Gewährleistung (Dichtigkeit des Daches) nicht akzeptabel sein kann.

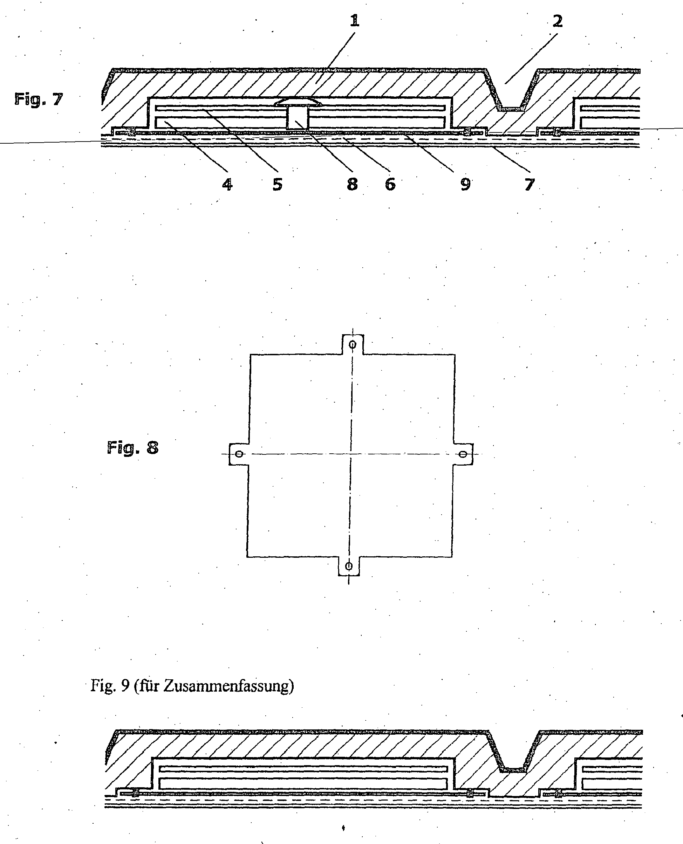

Fig. 7 zeigt die Ausbildung der rückseitigen Abdeckung mit einzelnen Deckeln 9, die den Bereich der Vertiefung 3 rückseitig überspannen und eine minimale Bewegung, die der Stift 8 beim Auftreffen von Hagelkörnern ausführt, auf die Bereiche voller Dicke der sonnenseitigen Abdeckplatte 1 überträgt. Diese Ausführungsform bietet auch ohne Verwendung des zusätzlichen Stiftes 8 bei der Herstellung des erfindungsgemäßen flexiblen Solarmoduls Vorteile, da die Verwendung von EVA-Schmelzklebefolie und Verarbeitung im Laminator entfällt. Die in Fig. 7 gezeigte Klebeschicht 6 kann eine normale Selbstklebefolie sein. Die rückseitige Abdeckung 7, in diesem Fall eine Kunststofffolie, dient im Wesentlichen zur Abdeckung der Zellenverbinder 10.

Fig. 8 zeigt einen einzelnen Deckel 9 aus starrem Material, beispielsweise Stahlblech. Jeder Deckel 9 besitzt vier Laschen mit Lochung. Es versteht sich, dass die einzelnen Deckel 9 Aussparungen zur Durchführung der Zellenverschaltung 10 aufweisen (nicht gezeigt). Die Deckel 9 werden, ein ausreichendes Tiefenmaß der Zellenvertiefungen 3 vorausgesetzt, ebenso wie die Solarzellen 4 in die Vertiefung 3 eingesetzt, jedoch liegen sie mit den Laschen auf den die Zelle umgebenden "dicken" Bereichen der sonnenseitigen Abdeckung 1 auf. Bei der Montage der Deckel 9 werden diese zunächst in Position gebracht und dann das stiftförmig durch die Lochung der Laschen greifende, thermoplastische Material der sonnenseitigen Abdeckung 1 durch Druck und Wärme so verformt, dass die Deckel 9 kraftschlüssig in ihrer Position fixiert sind. Die Verwendung metallischer Deckel 9 bietet außerdem den Vorteil, dass die Wärme von der Zelle besser nach hinten abgeleitet wird. Metallische Deckel 9 können vorteilhaft auch dann eingesetzt werden, wenn die Zelle ohne Abstützung 8 eingearbeitet wird (siehe Fig. 9). Insgesamt bietet die Verwendung von "Einzeldeckeln" 9 den Vorteil, dass diese aus starrem Material gefertigt werden können, also den Hangelschlag-Impuls abfangen können, ohne dass die Flexibilität des gesamten Solarmoduls hierdurch negativ beeinflusst wird.

### Bezugszeichenliste

- 1: Abdeckplatte
- 2: Nut
- 3: Vertiefung
- 4: Solarzelle
- 5: Gießharz
- 6: Klebeschicht
- 7: Abdeckung
- 8: Stift
- 9: Deckel
- 10: Zellenverbinder
- 11: Bypass-Diode
- 12: Durchgangsverdrahtung

## Patentansprüche

1. Solarmodul zur Dachintegration, bestehend aus mehreren kristallinen Siliziumzellen (4), die gemeinsam mit einer lichtdurchlässigen Abdeckung (1) versehen sind, in die auf der sonnenabgewandten Seite Vertiefungen (3) zur Aufnahme der Siliziumzellen (4) mit einer mindestens der Dicke der Siliziumzellen (4) entsprechenden Tiefe eingebracht sind, **dadurch gekennzeichnet, dass**
die lichtdurchlässige Abdeckung (1) aus einem hagelschlagfesten Kunststoff besteht und sonnenseitig gitterförmig eingeformte Nuten (2) in der Art eines Dünnfilmscharniers aufweist, zwischen denen auf der sonnenabgewandten Seite die jeweils eingeformten Vertiefungen (3) liegen.

2. Solarmodul nach Anspruch 1, **dadurch gekennzeichnet, dass** Solarzellen (4) aus kristallinem Silizium mit kleinen Abmessungen und vergleichsweise großer Dicke Verwendung finden, wobei die Leiterbahnen ("grid") verstärkt und duktil (bruchfest) ausgebildet sind.

3. Solarmodul nach Anspruch 1 oder 2, **dadurch gekennzeichnet, dass** die Einbettung der kristallinen Solarzellen (4) in die sonnenseitige Abdeckung (1) mittels transparentem, UV-beständigem Gießharz (5) erfolgt.

4. Solarmodul nach Anspruch 3, **dadurch gekennzeichnet, dass** das Gießharz (5) elektrisch leitfähig ist.

5. Solarmodul nach einem der vorhergehenden Ansprüche, **dadurch gekennzeichnet, dass** die Solarzellen (4) mittig eine Lochung besitzen und beim Einbau der Solarzellen (4) in die sonnenseitige Abdeckung (1) pro Solarzelle (4) eine nicht mit der Solarzelle (4) verbundene, stiftartige Abstützung (8), geeignet zum Übertrag von Kräften von der sonnenseitigen Abdeckung (1) auf eine modulrückseitige Abdeckung (7), eingebaut ist.

6. Solarmodul nach Anspruch 5, **dadurch gekennzeichnet, dass** die Abstützung (8) aus einem transparenten Kunststoff besteht.

7. Solarmodul nach einem der vorhergehenden Ansprüche, **dadurch gekennzeichnet, dass** die zur Aufnahme von Solarzellen (4) vorgesehenen Vertiefungen (3) mit einer oder mehreren Fresnel-Linsen-Prägungen ausgestattet sind.

8. Solarmodul nach einem der vorhergehenden Ansprüche, **dadurch gekennzeichnet, dass** die sonnenseitige Abdeckung (1) zusätzlich mit Vertiefungen zur Aufnahme von Zellenverbindern (10) und/oder zusätzlichen Vertiefungen zur Aufnahme von Bypass-Dioden (11) und/oder zusätzlichen Vertiefungen für die Aufnahme einer Durchgangsverdrahtung (12) ausgestattet ist.

9. Solarmodul nach einem der vorhergehenden Ansprüche, **dadurch gekennzeichnet, dass** die Reihenschaltung der Solarzellen (4) mäanderförmig erfolgt, wobei für jede Zellenreihe dort, wo diese mit der nächstfolgenden nicht mit Zellenverbindern (10) verschaltet ist, der Einbau einer Bypass-Diode (11) vorgesehen ist.

10. Solarmodul nach Anspruch 1 oder 5, **dadurch gekennzeichnet, dass** rückseitige Zellabdeckungen als einzelne, starre und metallische Deckel (9) ausgeführt sind, wobei zusätzlich als weitere Abdeckung (7) über die gesamte rückseitige Modulfläche eine flexible Kunststofffolie geklebt ist.
